Europäisches Patentamt

European Patent Office

Office européen des brevets

(11) Publication number: **0 055 571**
**B1**

(12) **EUROPEAN PATENT SPECIFICATION**

(45) Date of publication of patent specification: **20.03.85**

(21) Application number: **81305983.9**

(22) Date of filing: **21.12.81**

(51) Int. Cl.⁴: **H 03 K 19/003,**
**H 03 K 19/086, G 01 R 31/28**

(54) ECL integrated circuit.

(30) Priority: **25.12.80 JP 184563/80**

(43) Date of publication of application:
**07.07.82 Bulletin 82/27**

(45) Publication of the grant of the patent:
**20.03.85 Bulletin 85/12**

(84) Designated Contracting States:
**DE FR GB NL**

(56) References cited:
**US-A-3 430 071**

(73) Proprietor: **FUJITSU LIMITED**
**1015, Kamikodanaka Nakahara-ku**
**Kawasaki-shi Kanagawa 211 (JP)**

(72) Inventor: **Kanai, Yasunori**
**536-5-2-401, Ohmaru**
**Inagi-shi Tokyo 192-02 (JP)**

(74) Representative: **Billington, Lawrence Emlyn**
**et al**
**HASELTINE LAKE & CO Hazlitt House 28**
**Southampton Buildings Chancery Lane**
**London WC2A 1AT (GB)**

Courier Press, Leamington Spa, England.

## Description

The present invention relates to an ECL (Emitter Coupled Logic) integrated circuit including one or a plurality of individual ECL circuits which or each of which comprises an emitter-follower transistor as an output stage. It particularly relates to the ability to test such a circuit in order to detect poor dynamic function.

A previous proposal will be described referring to the following drawings:

Fig. 1 is a circuit diagram showing an emitter-follower circuit as the output stage of an individual ECL circuit;

Fig. 2 is a graph showing the input characteristics of a conventional individual ECL circuit;

Figs. 3 and 4 show response characteristics of an ECL circuit output in response to different test input repetition frequencies; and

Fig. 5A schematically shows an ECL integrated circuit as a whole, Fig. 5B is a pulse timing chart, and Fig. 5C shows an example of the combination logic circuit of Fig. 5A.

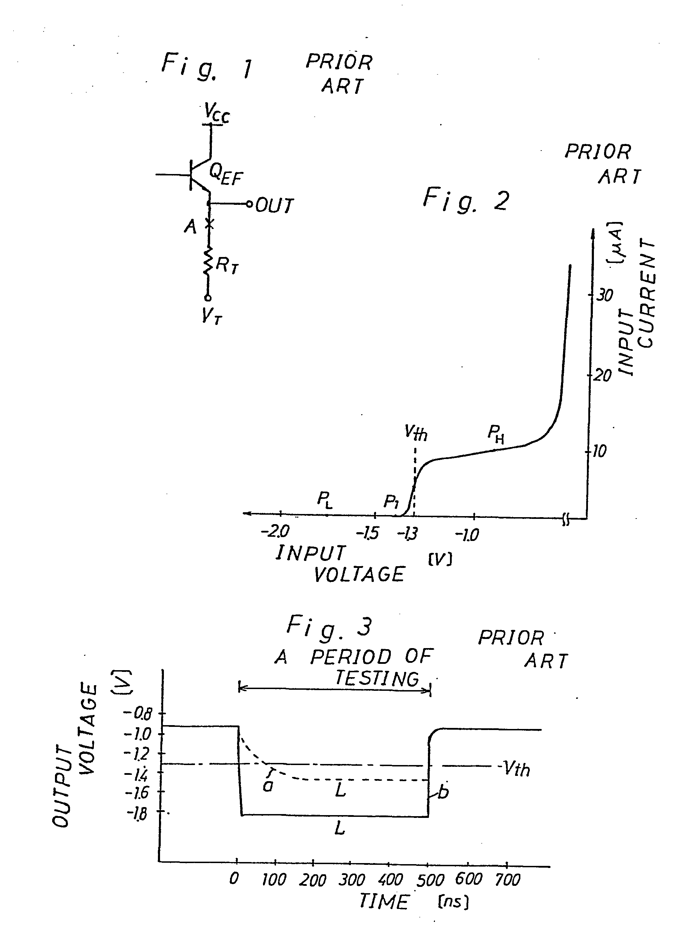

An individual ECL circuit whose fundamental element is an ECL gate in which emitters of a pair of transistors are connected with each other, and a reference voltage is applied to the base of one of the transistors with an input signal being applied to the base of the other thereof, often supplies its output OUT through an EF (emitter-follower) transistor as shown in Fig. 1. Namely, a base input of EF transistor $Q_{EF}$ is a collector output of an ECL gate which is not shown. The output stage of this ECL circuit is provided by connecting the emitter of transistor $Q_{EF}$ to an appropriate voltage $V_T$ through a pull-down resistor $R_T$. If the connection between the emitter of transistor $Q_{EF}$ and the resistor $R_T$ is cut or broken at a point A, for example, in such a circuit the arrangement of resistor $R_T$ becomes ineffective. This fault may be caused when the contact window for the resistor $R_T$ is not opened, when the pattern of the resistor $R_T$ is broken in the path thereof, or when wiring is broken.

A fault of this type is usually detected by a dynamic function test using a predetermined repetition frequency. When the repetition frequency is low, however, the poor dynamic circuit function can sometimes not be detected.

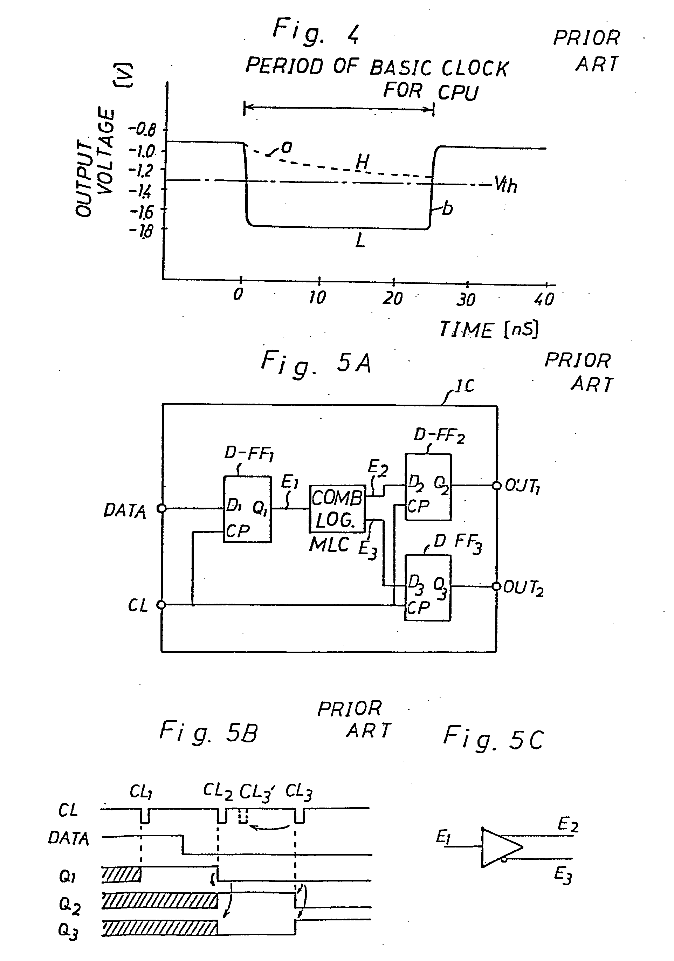

A conventional ECL circuit has an input characteristic as shown in Fig. 2 and H (high) level can be distinguished from L (low) level with a threshold voltage Vth of about —1.3V interposed between them. By way of example, $P_H$ represents a point at which H operation is usually carried out and $P_L$ a point at which L operation is usually carried out. A cut of connection at point A (see Fig. 1) is detected by such phenomenon that the level of output OUT will not drop lower than a certain voltage. This is natural when the emitter of transistor $Q_{EF}$ shown in Fig. 1 is kept open-circuit. However, said emitter is usually connected to other leads and arranged inside an integrated circuit IC (for example, combination logic circuit MLC shown in Fig. 5A) and resultant output signals $OUT_1$ and $OUT_2$ in response to test input data DATA are picked up via multiple-stages D-FF$_1$, D-FF$_2$ and D-FF$_3$ of this ECL circuit. In order to enable the break of connection at point A in Fig. 1 to be detected according to the function test of this ECL integrated circuit, it is therefore necessary to provide that the output OUT of a transistor $Q_{EF}$ at a preceding stage does not drop lower than the threshold voltage Vth of an ECL circuit at a subsequent stage during a test period when the output OUT would be low without the break at A, but in fact ought to be high with OUT open-circuit owing to a break at A being present.

The level of output OUT at the preceding stage whose connection is broken at point A is influenced by input current applied to ECL circuits at the subsequent stage shown in Fig. 2 and drops, as time passes, lower than the threshold voltage Vth as shown by a broken line (a) in Fig. 3 when the cycle of test is as long as shown in Fig. 3, that is, when the test repetition frequency is low (f=2MHz). A solid line (b) represents the voltage of output OUT under the condition that the resistor $R_T$ is correctly connected without any break at point A. If the input of transistor $Q_{EF}$ is at H level, output OUT thereof is also kept at H level and information indicating the break of connection at point A is not practically transmitted to the subsequent stage, so that the break of connection at point A can not be detected from outputs $OUT_1$ and $OUT_2$ in Fig. 5A according to a test in which low repetition frequency is employed. $P_1$ in Fig. 2 represents a point at which input voltage corresponding to that denoted by the broken line (a) in Fig. 3 is reduced to the minimum lower than Vth by input current applied to the subsequent stage.

Fig. 4 shows a waveform obtained when operation is carried out using the fundamental clock (f=40MHz) of a present-day ultra-large-scale electronic computer (CPU), and broken and solid lines (a) and (b) in Fig. 4 correspond to those in Fig. 3, respectively. The level of output OUT in Fig. 1 does not drop so much for a short time period, thus taking a voltage value larger than Vth at high repetition frequency of f=40MHz. Therefore, even if the dynamic function of an ECL circuit whose connection is cut at point A in Fig. 1 is found good by the test in which low repetition frequency of f=2MHz is employed, the ECL circuit certainly carries out malfunction when high repetition frequency of f=40MHz is employed.

The repetition frequency employed in a tester may therefore be increased to overcome the problem, but the fundamental clock of future ultra-large-sized electronic computers is expected to have high frequency of about 100—200 MHz. When a tester which can cover such a computer can not be obtained, it is impossible to carry out a satisfactory high frequency dynamic function test. The repetition frequency employed as the test frequency which is now put to practical use ranges from 10MHz to 20MHz at maximum, and that of the test frequency employed by the testers which are now manufactured for trial, ranges from 50MHz to 100MHz.

Fig. 5B is a pulse timing chart showing the operation of the ECL integrated circuit shown in Fig. 5A by means of outputs Q1—Q3 of D-type flip-flops D-FF1, D-FF2 and D-FF3, clock CL, and input data DATA. The flip-flop D-FF1 takes-in the value of input data DATA, e.g. H level, in response to a first clock pulse CL1. If the combination logic circuit MLC is a buffer/inverter circuit shown in Fig. 5C, for example, the flip-flop D-FF1 takes in L level in response to a next clock pulse CL2, while flip-flops D-FF2 and D-FF3 take-in outputs E2 und E3 of the combination logic circuit MLC, e.g. output data H and L respectively of the buffer/inverter circuit. Namely, H and L levels are taken-in by flip-flops D-FF2 and D-FF3. Flip-flops D-FF2 and D-FF3 take-in output E2 and E3 respectively of the combination logic circuit MLC, in response to a subsequent clock pulse CL3. When clock CL is at a low frequency, any fault or the influence of disconnection of a pull-down resistor, for example, is not indicated. However, when the clock becomes high in frequency, that is when a clock pulse is applied at the position of CL3', for example, the outputs are different from those obtained in the case of clock pule CL3, as indicated by Fig. 4. When the disconnection of resistor is at a common portion of buffer/inverter circuit, for example, outputs Q2 and Q3 of flip-flops D-FF2 and D-FF3 show no change at the clock CL3'.

It is known from Fig. 3 of US—A— 3 430 071 that the output of the output-side emitter-follower transistor of an ECL circuit may be accessed for parallel connection to another such output of another such circuit. In the present invention, access to the output of the emitter-follower transistor is employed for an entirely different purpose.

It is an object of the present invention to enable one to detect the faulty dynamic function of an ECL circuit employing low repetition test frequency.

According to the present invention there is provided an ECL integrated circuit comprising: a first ECL circuit which comprises an emitter-follower transistor at the output, a pull-down means connected to said emitter-follower transistor; and at least one second ECL circuit connected after the first ECL circuit so as to receive as input the output of the first ECL circuit; the ECL integrated circuit being characterised by a test terminal connected by a test circuit to a line coupling the output of said emitter follower transistor to the or each subsequent second circuit, the test circuit being such that when a suitable voltage is applied to the test terminal an auxiliary current will flow to said line from the test circuit, said auxiliary current having a value smaller than the current normally flowing to said pull-down means but larger than the input current flowing to the subsequent second circuit or circuits.

Embodiments of the present invention will be described in detail with reference to the following drawings: in which

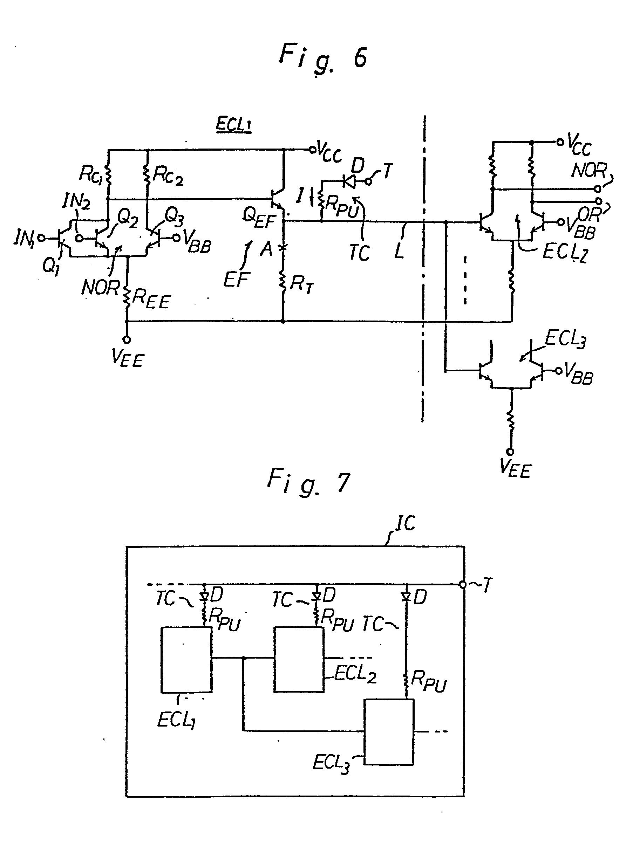

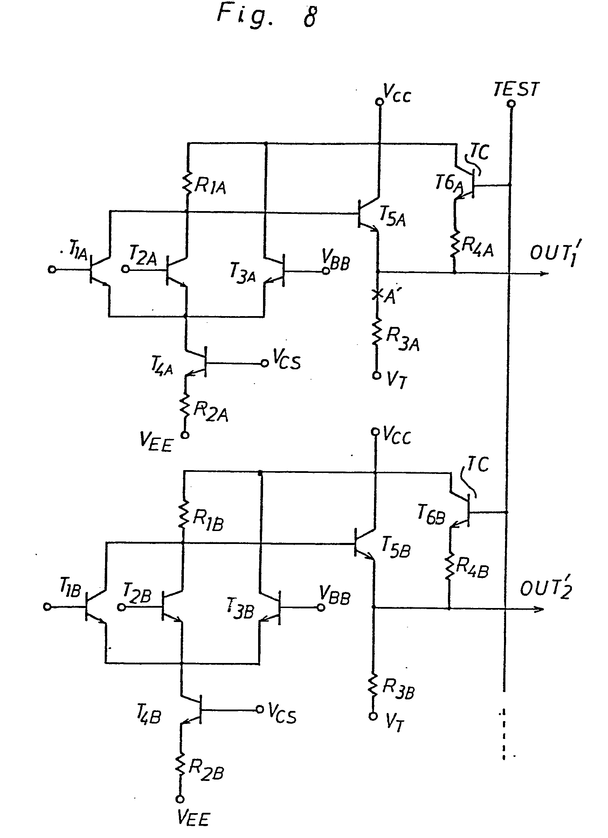

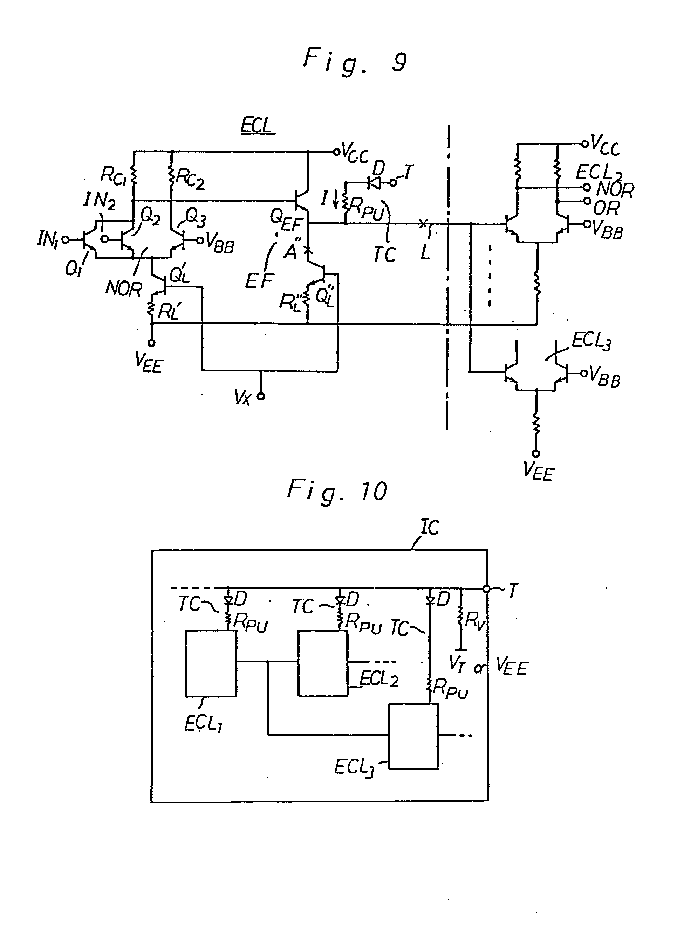

Figs. 6 and 7 are circuit diagrams showing a first embodiment of the present invention;

Fig. 8 is a circuit diagram showing a second embodiment of the present invention;

Fig. 9 is a circuit diagram showing a third embodiment of the present invention; and

Fig. 10 is a circuit diagram showing a fourth embodiment of the present invention.

Fig. 6 is a circuit diagram showing an embodiment of the present invention, in which $ECL_1$ represents an ECL circuit as a preceding stage and $ECL_2$, $ECL_3$, - - denote ECL circuits (or input portions thereof) as subsequent stages. ECL circuit $ECL_1$ comprises transistors Q1—Q3 whose emitters are connected with one another, an ECL gate or NOR gate NOR which includes collector-resistors $Rc_1$ and $Rc_2$ and an emitter-resistor $R_{EE}$, and an emitter-follower circuit EF for leading-out output via the gate. The NOR gate NOR serves to provide an output (or input of transistor $Q_{EF}$) of L level when input $IN_1$ or $IN_2$ is higher than a reference $V_{BB}$, and to supply an output of H level when both of inputs $IN_1$ and $IN_2$ are lower than $V_{BB}$. The emitter-follower circuit EF serves to sift or shift the voltage of the output of the NOR gate NOR, and has the same arrangement as that of the emitter-follower circuit shown in Fig. 1.

According to this embodiment of the present invention, a testing circuit TC, to or through which auxiliary current I, smaller than the current usually flowing to the pull-down resistor $R_T$, but larger than the sum of the input current flowing to the ECL circuits $ECL_2$, $ECL_3$, - - - as subsequent stages, is allowed to flow only at the time of test, is connected to a line L which extends from the emitter output of EF transistor $Q_{EF}$ in the ECL circuit $ECL_1$, to the ECL circuits $ECL_2$, $ECL_3$, - - - as the subsequent stages. The testing circuit TC employed in this embodiment includes a diode D and a pull-up resistor $R_{PU}$, connected in series between a testing terminal T lead-out outside an IC chip, and the line L, said diode D serving to prevent the backward flow of current. A testing circuit TC is arranged at the output stage of each of ECL circuits $ECL_1$, $ECL_2$, etc. as shown in Fig. 7.

The test terminal T is usually connected to a lowest potential $V_{EE}$ or VT, and is caused to be connected to a high potential $V_{CC}$, for example, at the time of test. Since the test terminal T is arranged as described above, no current consumption is normally caused in the testing circuit TC, and no problem that the ECL circuits are influenced by one another is caused at the

**0 055 571**

time of usual or normal operation of the ECL integrated circuit. When the terminal T is connected to $V_{cc}$ at the time of test, current 1 tends to flow corresponding to emitter potential of transistor $Q_{EF}$. If the emitter-follower circuit EF is normal without any disconnection at point A, little current I flows when the input of transistor $Q_{EF}$ is at H level, but flows to the resistor $R_T$ when said output is at L level. Therefore, H and L level outputs of ECL circuit $ECL_1$ are transmitted to the subsequent stage as they are.

If the emitter-follower circuit EF is disconnected at point A, current I continues to flow to the inputs of subsequent stages when the input of transistor $Q_{EF}$ is at L level. Therefore, it is not caused that output voltage drops, as shown in Fig. 3, as time passes, thus allowing the input voltage of subsequent stages to be kept at H level. This theoretically means malfunction, and a certain data DATA is therefore inputted to make outputs $OUT_1$ and $OUT_2$ different from their expected values, so that faulty dymamic function of an ECL circuit can be detected however low the test frequency may be.;

Fig. 8 is a circuit diagram showing a second embodiment of the present invention employed in two input OR circuits. Inputs of transistors $T_{1A}$ and $T_{2A}$ are bases thereof, and collectors thereof are connected via a resistor to a power source $V_{cc}$. The collectors thereof are also connected to the base of a transistor $T_{5A}$ whose collector is connected to the power source $V_{cc}$. The emitter of transistor $T_{5A}$ is connected via a resistor $R_{3A}$ to a power source $V_T$ and also to an output terminal $OUT_1$. The emitter of a transistor $T_{6A}$ whose collector is connected to the power source $V_{cc}$ is connected via a resistor $R_{4A}$ to the emitter of transistor $T_{5A}$. The emitter of transistor $T_{3A}$ whose collector is connected to the power source $V_{cc}$ is connected to emitters of transistors $T_{1A}$ and $T_{2A}$ and is also connected via a transistor $T_{4A}$ and a resistor $R_{2A}$ to a power source $V_{EE}$. To the base of transistor $T_{3A}$ is connected a power source $V_{BB}$ while to the base of transistor $T_{4A}$ a power source $V_{CS}$ is connected. The power source $V_{cc}$ serves as a power source for supplying operating current, the power source $V_T$ as a terminal power source, the power source $V_{BB}$ as a power source for supplying reference voltage, and the power source $V_{CS}$ as a power source for applying constant bias voltage to the transistor $T_{4A}$.

The transistor $T_{6A}$ and resistor $R_{4A}$ operate similarly to the diode D and resistor $R_{PU}$ shown in Fig. 6. Namely, voltage applied to a test terminal TEST is turned ON and the voltage of power source $V_{cc}$ is consequently applied to one terminal of resistor $R_{4A}$. A circuit connected to an output terminal $OUT_2$, is the same in arrangement as that just described and connected to the output terminal $OUT_1$. The bases of the transistors $T_{6A}$ and $T_{6B}$ in these circuits, these circuits being connected to the output

terminals $OUT_1$, and $OUT_2$, respectively, are connected to the test terminal TEST. The circuit shown in Fig. 8 is substantially the same as that shown in Fig. 6 except that current flowing into the test terminal TEST is different in value. Namely, the current flowing to the resistor flows from the test terminal T in Fig. 6, but the value of the current flowing in the second embodiment shown in Fig. 8 may be enough if it reaches about 1 per current amplifying ratio of transistor $T_{6A}$, because the ON/OFF action of the transistor is employed.

If the second embodiment shown in Fig. 8 is disconnected at a point A' for example, current continues to flow via the transistor $T_{6A}$ and resistor $R_{4A}$ to the output $OUT_1$, when the input of transistor $T_{5A}$ is at L level. Therefore, the output voltage does not drop, as shown in Fig. 3, as time passes, thus enabling the input voltage to a subsequent stage to be kept at H level. A circuit of the subsequent stage is omitted for the sake of clarity in the second embodiment shown in Fig. 8.

An operational description of Fig. 8 will now be made using practical numeral values.

It is assumed that the power source $V_{cc}$ is 0V or ground voltage, $V_{EE}$—5.2V and $V_T$—2.0V, and that the resistor $R_{3A}$ is 2K Ohm, and $R_{4A}$ 3K Ohm. It is further assumed that H level $V_{OH}$ is —0.8V and L level $V_{OL}$—1.2V. Providing that the test terminal TEST is of ground potential at L level output, current $I_{R3L}*$ flowing through $R_{3A}$ is:

$$I_{R3L}* = \frac{1}{R_{3A}+R_{4A}}(-V_{BE(T_{6A})}-V_T) \fallingdotseq 0.24 \ (mA)$$

wherein $V_{BE(T_{6A})}$ represents the voltage between the emitter and base of transistor $T_{6A}$ and is about 0.8V.

Providing that the voltage of terminal TEST is —2V, current $I_{R3L}$ flowing through $R_{3A}$ at the time of normal operation is:

$$I_{R3L} = \frac{1}{R_{3A}}(V_{OL}-V_T) \fallingdotseq 0.40 \ mA$$

Providing that collector current Ic of transistor $T_{4A}$ is 0.3mA, and that $h_{FE}$ of transistor at the subsequent stage is 100, base current $I_B$ at the subsequent stage is:

$$I_B = \frac{1}{1+h_{FE}} \times 0.3 \fallingdotseq 0.003mA$$

Providing that the maximum value of input connected to the output $OUT_1$, is 10, the sum of input current at the subsequent stage is 0.03mA at maximum. Namely, the relation of

$$I_{R3L} > I_{R3L}* > 0.03mA$$

is present.

Fig. 9 is a circuit diagram showing a third embodiment of the present invention. Resistors $R_{EE}$ and $R_T$ are used as pull-down means for the emitter-follower in the first embodiment shown in Fig. 6, but transistors $Q_{L'}$, $Q_{L''}$ and resistors $R_{L'}$, $R_{L''}$ are employed in the third embodiment. The principle according to which the circuit is operated is the same as that in the first embodiment shown in Fig. 6. Bias voltage $V_x$ is applied to the bases of transistors $Q_{L'}$ and $Q_{L''}$ in this case. Both of resistors $R_{EE}$ and $R_T$ in Fig. 6 are replaced by transistors $Q_{L'}$, $Q_{L''}$ and resistors $R_{L'}$, $R_{L''}$ in Fig. 9, but one of the resistors $R_{EE}$ and $R_T$ may be used together with any one of transistors $Q_{L'}$, $Q_{L''}$ and the corresponding resistor $R_{L'}$ or $R_{L''}$ in some cases. Namely, the resistor $R_{EE}$ may be used together with the transistor $Q_{L''}$ and resistor $R_{L''}$, or the resistor $R_T$ may be used together with the transistor $Q_{L'}$ and resistor $R_{L'}$.

Fig. 10 is a circuit diagram showing a fourth embodiment of the present invention. When the circuit shown in Fig. 7 is used practically, the test terminal T must be connected via the resistor to the power source $V_T$ or $V_{EE}$. The resistor is arranged inside the circuit in the case of the fourth embodiment shown in Fig. 10 thus enabling the operator to use the circuit with the test terminal opened.

According to the embodiments as described above, the incorrect dynamic function of a circuit which will follow malfunction at a time of normal use can be detected by a function test in which is employed a repetition frequency lower than the operating frequency employed for normal use.

## Claims

1. An ECL integrated circuit comprising: a first ECL circuit ($ECL_1$) which comprises an emitter-follower transistor ($Q_{EF}$, $T_{5A}$) at the output; a pull-down means ($R_T$, $Q_L''$, $R_L''$, $R_{3A}$) connected to said emitter-follower transistor ($Q_{EF}$, $T_{5A}$); and at least one second ECL circuit ($ECL_2$, $ECL_3$) connected after the first ECL circuit ($ECL_1$) so as to receive as input the output of the first ECL circuit ($ECL_1$); the ECL integrated circuit being characterised by a test terminal (T) connected by a test circuit (D, $R_{PU}$, $T_{6A}$, $R_{4A}$) to a line (L) coupling the output of said emitter-follower transistor ($Q_{EF}$, $T_{5A}$) to the or each subsequent second circuit ($ECL_2$, $ECL_3$), the test circuit being such that when a suitable voltage is applied to the test terminal (5) an auxiliary current (I) will flow to said line (L) from the test circuit, said auxiliary current (I) having a value smaller than the current normally flowing to said pull-down means but larger than the input current flowing to the subsequent second circuit or circuits.

2. An ECL integrated circuit according to claim 1, wherein said pull-down means comprises a transistor ($Q_L''$) whose base is coupled for connection to a first power source ($V_x$) and

whose emitter is coupled for connection via a resistor ($R_L''$) to a second power source ($V_{EE}$).

3. An ECL integrated circuit according to claim 1, wherein said pull-down means is or comprises a resistor ($R_T$, $R_{3A}$).

4. An ECL integrated circuit according to any preceding claim, wherein said test circuit comprises a resistor ($R_{PU}$) and a diode (D) connected in series with each other between the test terminal (T) and said line (L).

5. An ECL integrated circuit according to claim 1, 2 or 3, wherein said test circuit comprises a transistor ($T_{6A}$) and a resistor ($R_{4A}$), and the collector of said transistor is connected to a power source terminal ($V_{CC}$), the emitter thereof is connected via said resistor ($R_{4A}$) to said line (L), and the base thereof is connected to the test terminal (T).

6. An ECL integrated circuit according to any preceding claim, wherein to said test terminal (T) there is connected a resistor ($R_V$) whose other end is connected to a power source terminal ($V_T$ or $V_{EE}$).

7. An ECL integrated circuit according to any preceding claim, comprising a plurality of ECL circuits each of which has a respective test circuit as defined, the test circuits being connected in common to said test terminal (T).

## Revendications

1. Circuit intégré du type logique à couplage d'émetteur (ECL) comprenant: un premier circuit ECL ($ECL_1$) qui comprend un transistor à émetteur suiveur ($Q_{EF}$, $T_{5A}$) à la sortie; un moyen chuteur ($R_T$, $Q_{L''}$, $R_{L''}$, $R_{3A}$) connecté au transistor à émetteur suiveur ($Q_{EF}$, $T_{5A}$); et au moins un second circuit ECL ($ECL_2$, $ECL_3$) connecté à la suite du premier circuit ECL ($ECL_1$) de manière à ce qu'il reçoive comme signal d'entrée le signal de sortie du premier circuit ECL ($ECL_1$); le circuit intégré ECL étant caractérisé par une borne de contrôle (T) connectée par un circuit de contrôle (D, $R_{PU}$, $T_{6A}$, $R_{4A}$) à une ligne (L) reliant la sortie du transistor à émetteur suiveur ($Q_{EF}$, $T_{5A}$) au ou à chaque second circuit suivant ($ECL_2$, $ECL_3$), le circuit de contrôle étant tel que, lorsqu'une tension appropriée est appliquée à la borne de contrôle (5), un courant secondaire (I) passe jusqu'à la ligne (L) à partir du circuit de contrôle, le courant secondaire (I) ayant une valeur inférieure à celle du courant passant normalement jusqu'audit moyen chuteur mais supérieure à la valeur du courant d'entrée passant jusqu'au second circuit ou aux seconds circuits suivants.

2. Circuit intégré ECL selon la revendication 1, caractérisé en ce que ledit moyen chuteur comprend un transistor ($Q_{L''}$) dont la base est couplée pour être connectée à une première source de tension ($V_x$) et dont l'émetteur est couplé pour être connecté par l'intermédiaire d'une résistance ($R_{L''}$) à une seconde source de tension ($V_{EE}$).

3. Circuit intégré ECL selon la revendication 1, caractérisé en ce que ledit moyen chuteur est ou comprend une résistance ($R_T$, $R_{3A}$).

4. Circuit intégré ECL selon l'une quelconque des revendications 1 à 3, caractérisé en ce que le circuit de contrôle comprend une résistance ($R_{PU}$) et une diode (D) connectées en série entre la borne de contrôle (T) et la ligne (L).

5. Circuit intégré ECL selon l'une quelconque des revendications 1 à 3, caractérisé en ce que le circuit de contrôle comprend un transistor ($T_{6A}$) et une résistance ($R_{4A}$), le collecteur de transistor étant connecté à une borne de tension ($V_{CC}$), son émetteur étant connecté par l'intermédiaire de la résistance ($R_{4A}$) à la ligne (L) et sa base étant connectée à la borne de contrôle (T).

6. Circuit intégré ECL selon l'une quelconque des revendications 1 à 5, caractérisé en ce qu'une résistance ($R_V$) est connectée à la borne de contrôle (T), l'autre extrémité de cette résistance étant connectée à une borne de tension ($V_T$ ou $V_{EE}$).

7. Circuit intégré ECL selon l'une quelconque des revendications 1 à 6 caractérisé en ce qu'il comprend un ensemble de circuits ECL comportant chacun un circuit de contrôle respectif comme il a été défini, les circuits de contrôle étant connectés en commun à la borne de contrôle (T).

**Patentansprüche**

1. Integrierte ECL-Schaltung mit:

einer ersten ECL-Schaltung ($ECL_1$), die einen Emitterfolgetransistor ($Q_{EF}$, $T_{5A}$) an dem Ausgang umfaßt,

einer mit dem genannten Emitterfolgetransistor ($Q_{EF}$, $T_{5A}$) verbundenen Runterzieheinrichtung ($R_T$, $Q_L''$, $R_L''$, $R_{3A}$), und

wenigstens einer zweiten ECL-Schaltung ($ECL_2$, $ECL_3$), die der ersten ECL-Schaltung ($ECL_1$) so nachgeschaltet ist, daß sie die Ausgangszeichen der ersten ECL-Schaltung ($ECL_1$) als Eingangszeichen empfängt,

gekennzeichnet durch

einen Testanschlub (T), der über eine Testschaltung (D, $R_{PU}$, $T_{6A}$, $R_{4A}$) mit einer Leitung (L) verbunden ist, die den Ausgang des genannten Emitterfolgetransistors ($Q_{EF}$, $T_{5A}$) mit der oder jeder folgenden zweiten Schaltung ($ECL_2$, $ECL_3$) koppelt,

wobei die Testschaltung so ausgelegt ist, daß dann, wenn eine geeignete Spannung dem Testanschluß (5) zugeführt wird, von der Testschaltung zu der genannten Leitung (L) ein Hilfsstrom (I) fließt, dessen Wert kleiner als der Strom ist, der normalerweise zu der genannten Runterzieheinrichtung fließt, der jedoch größer als der Eingangsstrom ist, der zu der folgenden zweiten Schaltung oder zweiten Schaltungen fließt.

2. Integrierte ECL-Schaltung nach Anspruch 1, bei welcher die Runterzieheinrichtung einen Transistor ($Q_L''$) umfaßt, dessen Basis mit einer ersten Energieversorgungsquelle ($V_x$) verbunden ist und dessen Emitter über einen Widerstand ($R_L''$) mit einer zweiten Energieversorgungsquelle ($V_{EE}$) verbunden ist.

3. Integrierte ECL-Schaltung nach Anspruch 1, bei welcher die Runterzieheinrichtung aus einem Widerstand ($R_T$, $R_{3A}$) besteht.

4. Integrierte ECL-Schaltung nach einem der vorhergehenden Ansprüche, bei welcher die genannte Testschaltung einen Widerstand ($R_{PU}$) und eine Diode (D) umfaßt, die miteinander in Reihe liegend zwischen dem Testanschluß (T) und der genannten Leitung (L) angeschlossen sind.

5. Integrierte ECL-Schaltung nach Anspruch 1, 2 oder 3, bei welcher die genannte Testschaltung einen Tranistor ($T_{6A}$) und einen Widerstand ($R_{4A}$) umfaßt und der Kollektor des genannten Transistors mit einem Energiequellenanschluß ($V_{CC}$), der Emitter über den genannten Widerstand ($R_{4A}$) mit der genannten Leitung (L) und die Basis mit dem Testanschluß (T) verbunden ist.

6. Integrierte ECL-Schaltung nach einem der vorhergehenden Ansprüche, bei welcher an den genannten Testanschluß (T) ein Widerstand ($R_V$) angeschlossen ist, dessen anderes Ende mit einem Energiequellenanschluß ($V_T$ oder $V_{EE}$) verbunden ist.

7. Integrierte ECL-Schaltung nach einem der vorhergehenden Ansprüche, gekennzeichnet durch eine Anzahl von ECL-Schaltungen, von denen jede eine entsprechende Testschaltung, wie definiert, hat, wobei die Testschaltungen gemeinsam mit dem genannten Testanscluß (T) verbunden sind.

**0 055 571**

*Fig. 1* PRIOR ART

PRIOR ART *Fig. 2*

*Fig. 3* PRIOR ART

1

0 055 571

**Fig. 4**  PRIOR ART

PERIOD OF BASIC CLOCK FOR CPU

OUTPUT VOLTAGE [V] vs TIME [nS]

**Fig. 5A**  PRIOR ART

**Fig. 5B**  PRIOR ART

**Fig. 5C**

2

## Fig. 6

ECL₁

## Fig. 7

# Fig. 8

## Fig. 9

## Fig. 10